# EUROPEAN PATENT SPECIFICATION

(11) **EP 3 297 772 B1**
(45) Date of publication and mention of the grant of the patent: **01.01.2020**
(21) Application number: 16800768.0
(22) Date of filing: 27.05.2016
(51) Int. Cl.: C23C 18/18, C23C 18/16, H05K 3/24

(54) **METHOD FOR ELECTROLESSLY PLATING A METAL ON A COPPER OR COPPER ALLOY**
VERFAHREN ZUR STROMLOSEN PLATTIERUNG EINES METALLS AUF KUPFER ODER EINE KUPFERLEGIERUNG
PROCÉDÉ DE DÉPÔT AUTOCATALYTIQUE D'UN MÉTAL SUR DU CUIVRE OU UN ALLIAGE DE CUIVRE

(30) Priority: 28.05.2015 US 201514723562
(43) Date of publication of application: 28.03.2018
(73) Proprietor: MacDermid, Incorporated, Waterbury, CT 06702 (US)
(72) Inventor: JIN, Lei, Unionville, CT 06085 (US); LONG, Ernest, Burlington, CT 06013 (US); KONEFAL, Alexander, Berlin, CT 06037 (US); YAN, Wei, Waterbury, CT 06708 (US)
(74) Representative: Jenkins, Peter David
(86) International application number: PCT/US2016/034510
(87) International publication number: WO 2016/191632

(56) References cited:
- JP-A- 2006 316 350
- US-A- 3 489 603
- US-A- 5 147 692
- US-A- 5 212 138
- US-A- 5 843 517
- US-A- 5 846 598
- US-A1- 2009 035 940
- US-A1- 2010 075 496
- US-A1- 2010 285 660
- US-A1- 2012 321 781

## Description

### FIELD OF THE INVENTION

The present invention relates generally to a pretreatment solution for electroless plating and method for using a pretreatment solution to prepare a surface for electroless plating

### BACKGROUND OF THE INVENTION

Articles with exposed copper and copper alloy surfaces are typically prepared for electroless plating by cleaning the surface, etching the surface, and catalytically activating the surface prior to electroless plating.

While electroless plating often involves several pretreatment steps, the pretreatment step of activation has a strong effect on the initiation of the electroless plating that follows. This invention relates to electrolessly plating exposed copper and copper alloys on the surface of an article, which do not typically initiate electroless plating without some type of catalyst present.

Traditionally, a palladium catalyst is used to provide active plating sites on the exposed copper and copper alloy surfaces. The most commonly used activation method uses a solution of palladium chloride in hydrochloric acid. Palladium chloride rapidly attacks and forms an immersion deposit on copper and copper alloys. A common problem known within the art of electroless plating on a palladium activated copper or copper alloy surface on a substrate is called "bridging" or "extraneous" plating. This is when plating occurs on areas other than the exposed copper or copper alloy and can form an unintended electrical connection between lines or traces that may cause an electrical short in the finished product. In the case of a printed circuit board (PCB), the dielectric (insulator) often plates in the electroless solution when a palladium catalyst is used, while the desire is to restrict the plating to the metal conductor (typically copper). Printed circuit boards are increasingly required to have very fine lines and spaces and therefore the presence of extraneous can cause bridging between these finely spaced traces. The invention described herein can be useful in preparing exposed copper or copper alloys for electroless plating on the following, but not limited to: PCBs, light emitting diodes, electrical connectors, molded interconnect devices, and solar panels.

There have been attempts to cure the problem of extraneous plating and bridging as set out in U.S. Patents US 6,156,218, US 5,212,138, and US 5,167,992 to prevent plating on areas other than copper or copper alloy to be plated. These patents are hereby incorporated by reference in their entirety.

In U.S. 6,156,218 the inventors found that a thiosulfate solution prior to electroless plating would inactivate the Pd catalyst remaining in the space between the circuits to prevent "bridging" during electroless nickel deposition. The thiosulfate solution comprises a compound selected from the group consisting of sodium thiosulfate, potassium thiosulfate, and ammonium thiosulfate. The catalyst is taught to activate the copper while the thiosulfate solution inactivates the catalyst. The thiosulfate solutions were used to poison any remaining palladium catalyst.

In U.S. 5,212,138, the catalyst composition used for initiation of an electroless metal deposit is a combination of a palladium alkyl halide salt and a Group VIII precious metal salt. The teachings show that the combination of palladium and ruthenium metal catalysts will work more effectively because their rate of attack on the copper substrate is significantly decreased, yet still catalytically active enough to initiate electroless deposition. Although this combination of metal catalysts successfully activated the surface for electroless plating, the inventors believe the palladium is still aggressive enough to cause extraneous plating and possibly bridging. Activation which does not require the use of a palladium catalyst is desired.

U.S. patent 5,167,992 uses a deactivation step after an activation step to prevent electroless plating on the dielectric surface without deactivating the catalyst on the metal conductor. The activation solution can be palladium, gold, or platinum. The deactivation solution is an acidic solution capable of removing the metallic salts on the substrate or a nonaqueous solution would be preferred for copper conductors.

The idea of using only a ruthenium based activator (without palladium) was not previously considered useful because it has been found that ruthenium is a weaker catalyst than palladium in reference to the time it takes to initiate electroless plating in subsequent plating steps. The inventors have found that by using a pre treatment solution comprising a divalent sulfur compound or compounds allows for reduced initiation time in subsequent electroless plating baths compared to using the ruthenium activator without the divalent sulfur compound or combination of divalent sulfur compounds in the pre treatment solution. Additionally, the use of ruthenium activation eliminates extraneous plating and chances for bridging to occur.

### SUMMARY OF THE INVENTION

It is an object of the present invention to provide an improved method of preparing an article with exposed copper or copper alloy for electroless metal plating. The inventors have surprisingly discovered that by using a ruthenium based activation bath followed by a pre treatment solution comprising a divalent sulfur compound, prior to an electroless plating bath, decreases the initiation time for metal plating to occur in the electroless plating bath and additionally eliminates extraneous plating, which can be the source of bridging and electrical shorts. The use of ruthenium in the activation bath is believed to be responsible for the elimination of any extraneous plating as it historically results in very slow initiation times during electroless plating. The pre treatment solution comprising divalent sulfur, used after the ruthenium activation step, is believed to cause the ruthenium activated copper or copper alloy to become more receptive to electroless metal plating, by further activating the copper or copper alloy. The results of this invention are both surprising and unexpected since the use of ruthenium is not common due to long initiation times during subsequent electroless metal plating and the use of sulfur containing pre treatments before electroless plating are typically used to deactivate or stop plating on initiation sites to prevent extraneous plating. Sulfur treatments are generally considered to be catalytic poisons.

It is another object of the present invention to provide a method of activating copper or copper alloys for subsequent electroless plating that does not require a palladium catalyst.

It is still another object of the present invention to provide a method of using ruthenium as a catalyst to initiate electroless plating.

It is still another object of the present invention to provide a method of using ruthenium as a catalyst followed by a pre treatment solution for electroless plating comprising a divalent sulfur compound, which prevents extraneous plating and increases initiation time in subsequent electroless metal plating baths.

To that end, in one embodiment, the present invention relates generally to a pretreatment method for producing an article with exposed copper or copper alloy without extraneous plating while providing acceptable initiation time on the copper or copper alloy during subsequent electroless metal plating, the method comprising, in order, the steps:
a) optionally cleaning and/or microetching the article with exposed copper or copper alloy to be plated;
b) immersing the article with exposed copper or copper alloy in a ruthenium based activation solution that does not contain palladium;
c) immersing the article in a solution comprising a divalent sulfur compound;
d) electrolessly metal plating said article; wherein the metal plating does not occur on areas other than the exposed copper or copper alloy.

### DETAILED DESCRIPTION OF THE PREFERRED EMBODIMENTS

The inventors of the present invention have found that the use of divalent sulfur compounds in a solution to be used following a ruthenium based activation composition that does not comprise palladium, allows for no extraneous plating and acceptable initiation times during subsequent electroless plating. Thus, the pre treatment compositions described herein allow for electroless plating on copper and copper alloys exposed on article without plating on other areas of the article surface. In addition, the method described herein can be used prior to various types of electroless plating baths, including but not limited to, nickel, cobalt, silver and gold.

To that end, in one embodiment, the present invention relates generally to a pre treatment method for producing an article with exposed copper or copper alloy without extraneous plating while providing acceptable initiation time on the copper or copper alloy during subsequent electroless metal plating, the method comprising, in order, the steps:
a) optionally cleaning and/or microetching the article with exposed copper or copper alloy to be plated;
b) immersing the article with exposed copper or copper alloy in a ruthenium based activation solution that does not contain palladium;
c) immersing the article in a solution comprising a divalent sulfur compound;
d) electrolessly metal plating said article; wherein the metal plating does not occur on areas other than the exposed copper or copper alloy.

The inventors of the present invention have found that the inclusion of a divalent sulfur compound or combinations thereof into the pre treatment for electroless plating, following use of a ruthenium activator, allows for elimination of extraneous and reasonable initiation times during electroless plating. While not wishing to be bound by theory, the inventors believe that this is likely due to use of a ruthenium catalyst which does not cause extraneous plating, the ability of the divalent sulfur compounds to aid in initiation of electroless plating on the copper and copper alloys coated by a ruthenium catalyst, and the ability of the divalent sulfur compounds to prevent the ruthenium from passivating or oxidizing prior to electroless plating.

The initiation time for electroless plating to commence on exposed copper was measured, comparing ruthenium activation followed by a 5% sulfuric acid dip to the current invention. The current invention uses ruthenium activation followed by a pre treatment solution for electroless plating containing a divalent sulfur compound or combination of divalent sulfur compounds.

Table 1 presents a series of tests run by the inventors in which a PCB coupon with exposed copper areas was processed through a ruthenium activation solution, followed by a solution of 5% sulfuric acid, and then immersed in an electroless nickel plating bath. The time to begin plating (Initiation Time) was measured during five different runs. The initiation times varied from just over three minutes to longer than 10 minutes in one instance. It is desirable to have initiation of plating in less than two minutes, which is based on typical initiation times when palladium catalysts are used prior to electroless plating.

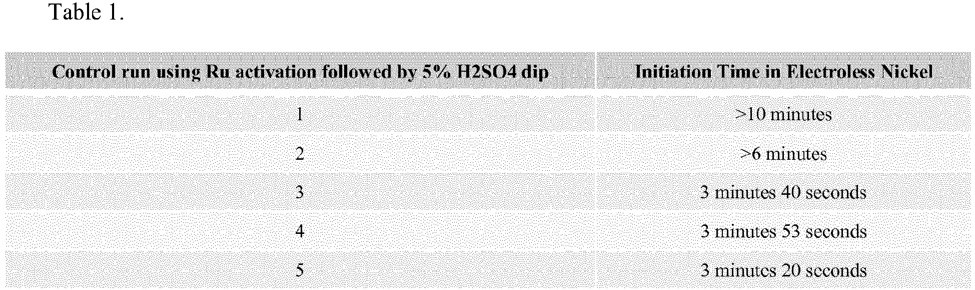

In order to make the plating cycle more efficient, reduced initiation times are required which in turn reduces the total time needed in the electroless plating bath.

The same type of test coupons used to generate the data of Table 1 were also used to compare the current pre treatment invention to a typical ruthenium activation cycle prior to electroless plating as shown in table 2. Table 2 additionally shows the amount of extraneous on the PCB after using the current invention.

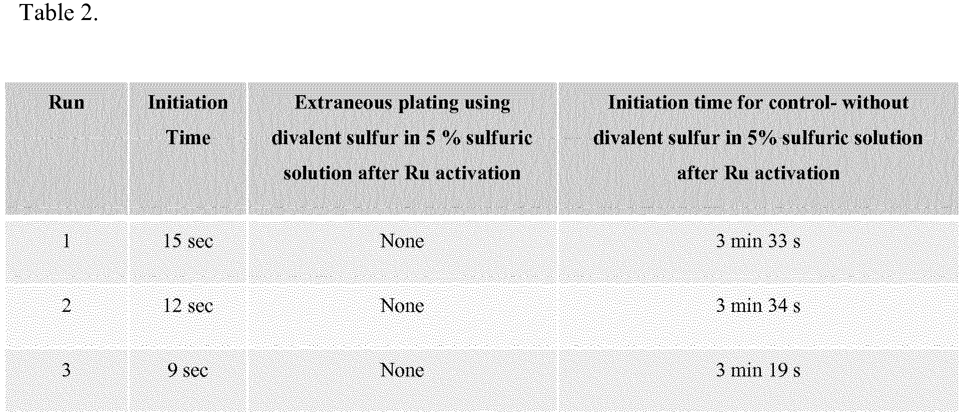

Based on the results of table 2, it was determined that by using a solution comprising a divalent sulfur compound or combinations of divalent sulfur compounds after a ruthenium based activation solution and prior to electroless plating, initiation time could be reduced to less than thirty seconds while preventing extraneous plating.

A typical process cycle for preparing an article with exposed copper or copper alloy for electroless plating consists of optionally cleaning and/or micro etching the exposed copper or copper alloy, activating using a precious metal catalyst, immersing the article in an acid based solution after activation and finally electrolessly plating the areas of exposed copper or copper alloy.

While palladium activation is most common, the problem of extraneous plating during subsequent elecroless plating steps is well known. The inventors have chosen to use ruthenium activation which helps to avoid the presence of extraneous plating but often results in unreasonably slow initiation times in the subsequent electroless metal plating step. In some embodiments, there are no palladium compounds present in the activation solution of the current invention. While the acidic dip prior to electroless plating did not decrease the initiation times after using a ruthenium based activator solution, the addition of a divalent sulfur compound or combinations of divalent sulfur compounds to the acidic dip allowed for subsequent electroless plating initiation times of less than one minute. As shown in table 2, initiation times of less than 30 seconds were found.

The ruthenium activator comprises a source of ruthenium ions and an acid. In some embodiments, there are not any palladium compounds or palladium catalysts present in the activation or pre treatment solutions used in this invention. The article with exposed copper or copper alloy to be plated can be immersed in the ruthenium activator for as little as 10 seconds or as long as 10 minutes, with 1-5 minutes being preferred. The ruthenium activation step is followed by a water rinse and then the article is immersed in the pre treatment solution comprising one or more divalent sulfur compounds. This electroless plating pre treatment can be used for 1 second up to 5 minutes, most preferably 30 seconds to 3 minutes. After being immersed in the divalent sulfur pre treatment, the article is rinsed with water and then immersed into the desired electroless plating bath. The initiation time for metal plating to occur was reduced compared to a pre treatment without any divalent sulfur compound. Additionally, there was no extraneous plating or bridging seen as a result of using the current invention.

The inventors have found that a divalent sulfur compound or combination of such compounds, including but not limited to sulfur containing aliphatic carboxylic acids, alcohols and their derivatives, sulfur containing aromatic/aliphatic carboxylic acids, sulfur containing acetylene compounds, aromatic sulfides, thiophenes, thionaphthenes, acyl thio-ketals, thioacetals, thioarols and thiazoles are useful in the pre treatment solution prior to electroless plating.

Examples of divalent sulfur compounds that may be used alone or in combination in the current invention are as follows: β-thio-dipropionic acid, (methylene-dithio)-diacetic acid, 3-hydroxy-thionaphthene-2-carboxylic acid, 2-(α-hydroxy-ethyl-thio)-4-ethylbenzoic acid, dilauryl sulfide, distearyl dithiodipropionate, thiobenzoic acid, 1-octadecanethiol, S-(2-carboxyphenyl)-thioglycolic acid, thiourea, thiodiglycolic acid, dithiodiglyoclic acid, 3-(amidinothio)-1-propanesulfonic acid, thiophene, 2,2'-thiodiethanol, 4,4'-dinitro-diphenyl-sulfide-6,6'-disulfonic acid, 2-(m-aminophenyl)-7-hydroxy-naptho-(2,3-d) thiazole-5-sulfonic acid, 2-hydroxy thionaphthene, 2-thiophene carboxylic acid, thiosalicylic acid, thiolactic acid, L-cysteine, cysteamine, thiodiacetic acid, potassium tetrathionate, 2,2'-thio-di(5-amino-benzene sulfonic acid), 3-carboxymethyl-thio-2-anthraquinone carboxylic acid, 4-hydroxy thiophenol, (2-nitro-4-acetamidophenyl-thio)-acetic acid, S(8-chloro-1-naphthyl)-thioglycolic acid, (p-chlorophenyl-thio)-acetic acid, 4-amino thiophenol, and 2-amino thiophenol.

The divalent sulfur compound or combination of such compounds is present in the pre treatment solution of the current invention at a concentration of at least 0.1 mg/L. The divalent sulfur compound or combination of divalent sulfur compounds may be present in total anywhere from 0.1 mg/L up to 10 000 mg/L. The divalent sulfur compound or combination of compounds is preferably used from 0.5 mg/L to 5000 mg/L, and most preferably from 1 mg/L up to 1000 mg/L.

A mineral acid was found to be useful in the pre treatment solution with the one or more divalent sulfur compounds. The acid may be present anywhere from 1% up to 20% by volume. The concentration of the mineral acid is most preferably 2%-8% by volume. The mineral acid is most preferably sulfuric acid.

Other additives have been contemplated as useful for incorporation into the pre treatment solution to be used before electroless metal plating such as surfactants, pH adjustors, and/or complexing agents. These additives are commonly known to a person who is skilled in the art and are not considered limiting to the scope of the current invention.

The invention as described herein is a novel and unexpected pre treatment method for preventing extraneous plating and having quick initiation times in electroless plating baths when using a ruthenium based activator. The invention described herein is thought to be useful for a wide variety of applications wherein a copper or copper alloy is to be electrolessly metal plated.

## Claims

1. A method for electrolessly plating a metal on a copper or copper alloy comprising the steps of:
a) activating the copper or copper alloy in a solution comprising ruthenium metal ions;
b) immersing the copper or copper alloy in a pre treatment solution comprising one or more divalent sulfur compounds;
c) immersing the copper or copper alloy in an electroless metal plating bath.

2. The method according to claim 1, wherein the solution comprising ruthenium metal ions does not comprise any palladium compounds

3. The method according to claim 1 or claim 2 wherein the copper or copper alloy is cleaned and/or microetched prior to the step of activating the copper or copper alloy.

4. The method according to claim 2 or claim 3, wherein the divalent sulfur compound or combination of divalent sulfur compound in the pre treatment solution is selected from β-thio-dipropionic acid, (methylene-dithio)-diacetic acid, 3-hydroxy-thionaphthene-2-carboxylic acid, 2-(α-hydroxy-ethyl-thio)-4-ethylbenzoic acid, dilauryl sulfide, distearyl dithiodipropionate, thiobenzoic acid, 1-octadecanethiol, S-(2-carboxyphenyl)-thioglycolic acid, thiourea, thiodiglycolic acid, dithiodiglyoclic acid, 3-(amidinothio)-1-propanesulfonic acid, thiophene, 2,2'-thiodiethanol, 4,4'-dinitro-diphenyl-sulfide-6,6'-disulfonic acid, 2-(m-aminophenyl)-7-hydroxy-naptho-(2,3-d) thiazole-5-sulfonic acid, 2-hydroxy thionaphthene, 2-thiophene carboxylic acid, thiosalicylic acid, thiolactic acid, L-cysteine, cysteamine, thiodiacetic acid, potassium tetrathionate, 2,2'-thio-di(5-aminobenzene sulfonic acid), 3-carboxymethyl-thio-2-anthraquinone carboxylic acid, 4-hydroxy thiophenol, (2-nitro-4-acetamidophenyl-thio)-acetic acid, S(8-chloro-1-naphthyl)-thioglycolic acid, (p-chlorophenyl-thio)-acetic acid, 4-amino thiophenol, and 2-amino thiophenol.

5. The method according to claim 2 or claim 3, wherein the concentration of the divalent sulfur compound or combination of divalent sulfur compounds is from 0.1 mg/L to 10,000 mg/L.

6. The method according to claim 5, wherein the concentration of the divalent sulfur compound or combination of divalent sulfur compounds is from 0.5 mg/L to 5000 mg/L.

7. The method according to claim 6, wherein the concentration of the divalent sulfur compound or combination of divalent sulfur compounds is from 1.0 mg/L to 1000 mg/L.

8. The method according to claim 2 or claim 3, wherein the pre treatment solution further comprises a mineral acid.

9. The method according to claim 8, wherein the mineral acid is sulfuric acid.

10. The method according to claim 8, wherein the mineral acid concentration is 1% to 20% by volume.

11. The method according to claim 2 or claim 3, wherein the initiation time in an electroless plating bath is less than two minutes.

12. The method according to claim 11, wherein the initiation time in an electroless plating bath is less than one minute.

13. The method according to claim 12, wherein the initiation time in an electroless plating bath is less than 30 seconds.

14. The method according to claim 2 or claim 3, wherein there is no extraneous plating or bridging on the article.

15. The method according to claim 2 or claim 3, wherein the pre treatment solution further comprises a pH adjuster.

16. The method according to claim 2 or claim 3, wherein the pre treatment solution further comprises a surfactant.

17. The method according to claim 2 or claim 3, wherein the pre treatment solution further comprises a complexor.

## Patentansprüche

1. Verfahren zur stromlosen Plattierung eines Metalls auf ein Kupfer oder eine Kupferlegierung, das die folgenden Schritte umfasst:
a) Aktivieren des Kupfers oder die Kupferlegierung in einer Lösung, die Rutheniummetall-Ionen umfasst;
b) Eintauchen des Kupfers oder der Kupferlegierung in eine Vorbehandlungslösung, die eine oder mehrere zweiwertige Schwefelverbindungen umfasst;
c) Eintauchen des Kupfers oder der Kupferlegierung in ein stromloses Metallplattierungsbad.

2. Verfahren nach Anspruch 1, wobei die Lösung, die Rutheniummetall-Ionen umfasst, keinerlei Palladiumverbindungen umfasst.

3. Verfahren nach Anspruch 1 oder 2, wobei das Kupfer oder die Kupferlegierung vor dem Schritt des Aktivierens des Kupfers oder der Kupferlegierung gereinigt und/oder mikrogeätzt wird.

4. Verfahren nach Anspruch 2 oder 3, wobei die zweiwertige Schwefelverbindung oder die Kombination von zweiwertigen Schwefelverbindungen in der Vorbehandlungslösung aus β-Thiodipropionsäure, (Methylendithio)diessigsäure, 3-Hydroxythionaphthen-2-carbonsäure, 2-(α-Hydroxyethylthio)-4-ethylbenzoesäure, Dilaurylsulfid, Distearyldithiodipropionat, Thiobenzoesäure, 1-Octadecanthiol, S-(2-Carboxyphenyl)thioglykolsäure, Thioharnstoff, Thiodiglykolsäure, Dithioglykolsäure, 3-(Amidinothio)-1-propansulfonsäure, Thiophen, 2,2'-Thiodiethanol, 4,4'-Dinitrodiphenylsulfid-6,6'-disulfonsäure, 2-(m-Aminophenyl)-7-hydroxynaphtho-(2,3-d)-thiazol-5-sulfonsäure, 2-Hydroxythionaphthen, 2-Thiophencarbonsäure, Thiosalicylsäure, Thiomilchsäure, L-Cystein, Cysteamin, Thiodiessigsäure, Kaliumtetrathionat, 2,2'-Thiodi-(5-aminobenzolsulfonsäure), 3-Carboxymethylthio-2-anthrachinoncarbonsäure, 4-Hydroxythiophenol, (2-Nitro-4-acetamidophenylthio)essigsäure, S-(8-Chlor-1-naphthyl)thioglykolsäure, (p-Chlorphenylthio)essigsäure, 4-Aminothiophenol und 2-Aminothiophenol ausgewählt ist.

5. Verfahren nach Anspruch 2 oder 3, wobei die Konzentration der zweiwertigen Schwefelverbindung oder der Kombination von zweiwertigen Schwefelverbindungen von 0,1 mg/L bis 10.000 mg/L beträgt.

6. Verfahren nach Anspruch 5, wobei die Konzentration der zweiwertigen Schwefelverbindung oder der Kombination von zweiwertigen Schwefelverbindungen von 0,5 mg/L bis 5000 mg/L beträgt.

7. Verfahren nach Anspruch 6, wobei die Konzentration der zweiwertigen Schwefelverbindung oder der Kombination von zweiwertigen Schwefelverbindungen von 1,0 mg/L bis 1000 mg/L beträgt.

8. Verfahren nach Anspruch 2 oder 3, wobei die Vorbehandlungslösung weiterhin eine Mineralsäure umfasst.

9. Verfahren nach Anspruch 8, wobei die Mineralsäure Schwefelsäure ist.

10. Verfahren nach Anspruch 8, wobei die Mineralsäurekonzentration 1 Vol.-% bis 20 Vol.-% beträgt.

11. Verfahren nach Anspruch 2 oder 3, wobei die Initiationszeit in einem stromlosen Plattierungsbad weniger als zwei Minuten beträgt.

12. Verfahren nach Anspruch 11, wobei die Initiationszeit in einem stromlosen Plattierungsbad weniger als eine Minute beträgt.

13. Verfahren nach Anspruch 12, wobei die Initiationszeit in einem stromlosen Plattierungsbad weniger als 30 Sekunden beträgt.

14. Verfahren nach Anspruch 2 oder 3, wobei keine äußere Plattierung oder Brückenbildung an dem Gegenstand vorliegt.

15. Verfahren nach Anspruch 2 oder 3, wobei die Vorbehandlungslösung weiterhin einen pH-Einsteller umfasst.

16. Verfahren nach Anspruch 2 oder 3, wobei die Vorbehandlungslösung weiterhin eine grenzflächenaktive Substanz umfasst.

17. Verfahren nach Anspruch 2 oder 3, wobei die Vorbehandlungslösung weiterhin einen Komplexbildner umfasst.

## Revendications

1. Procédé de dépôt autocatalytique d'un métal sur du cuivre ou un alliage de cuivre, comprenant les étapes consistant à :
a) activer le cuivre ou l'alliage de cuivre dans une solution comprenant des ions métalliques ruthénium ;
b) immerger le cuivre ou l'alliage de cuivre dans une solution de prétraitement comprenant un ou plusieurs composés de soufre divalent ;
c) immerger le cuivre ou l'alliage de cuivre dans un bain de dépôt autocatalytique.

2. Procédé selon la revendication 1, où la solution comprenant des ions métalliques ruthénium ne comprend aucun composé de palladium.

3. Procédé selon la revendication 1 ou la revendication 2, où le cuivre ou l'alliage de cuivre est nettoyé et/ou microgravé avant l'étape d'activation du cuivre ou de l'alliage de cuivre.

4. Procédé selon la revendication 2 ou la revendication 3, où le composé de soufre divalent ou une combinaison de composés de soufre divalent dans la solution de prétraitement est sélectionné parmi les suivants : acide β-thiodipropionique, acide (méthylène-dithio)-diacétique, acide 3-hydroxy-thionaphtène-2-carboxylique, acide 2-(α-hydroxy-éthyl-thio)-4-éthylbenzoïque, disulfure de lauryle, dithiodipropionate de distéaryle, acide thiobenzoïque, 1-octadécanethiol, acide S-(2-carboxyphényl)-thioglycolique, thiourée, acide thiodiglycolique, acide dithiodiglyoclique, acide 3-(amidinothio)-1-propanesulfonique, thiophène, 2,2'-thiodiéthanol, acide 4,4'-dinitro-diphényl-sulfure-6,6'-disulfonique, acide 2-(m-aminophényl)-7-hydroxy-naphto-(2,3-d)-thiazol-5-sulfonique, 2-hydroxy-thionaphtène, acide 2-thiophène-carboxylique, acide thiosalicylique, acide thiolactique, L-cystéine, cystéamine, acide thiodiacétique, tétrathionate de potassium, acide 2,2'-thio-di(5-amino-benzène)sulfonique, acide 3-carboxyméthyl-thio-2-anthraquinon-carboxylique, 4-hydroxy-thiophénol, acide (2-nitro-4-acétamidophényl-thio)-acétique, acide S(8-chloro-1-naphtyl)-thioglycolique, acide (p-chlorophényl-thio)-acétique, 4-amino-thiophénol et 2-amino-thiophénol.

5. Procédé selon la revendication 2 ou la revendication 3, où la concentration en le composé de soufre divalent ou la combinaison de composés de soufre divalent va de 0,1 mg/l à 10 000 mg/l.

6. Procédé selon la revendication 5, où la concentration en le composé de soufre divalent ou la combinaison de composés de soufre divalent va de 0,5 mg/l à 5 000 mg/l.

7. Procédé selon la revendication 6, où la concentration en le composé de soufre divalent ou la combinaison de composés de soufre divalent va de 1,0 mg/l à 1 000 mg/l.

8. Procédé selon la revendication 2 ou la revendication 3, où la solution de prétraitement comprend en outre un acide minéral.

9. Procédé selon la revendication 8, où l'acide minéral est l'acide sulfurique.

10. Procédé selon la revendication 8, où la concentration en l'acide minéral va de 1 % à 20 % en volume.

11. Procédé selon la revendication 2 ou la revendication 3, où le temps d'initiation dans un bain de dépôt autocatalytique est inférieur à deux minutes.

12. Procédé selon la revendication 11, où le temps d'initiation dans un bain de dépôt autocatalytique est inférieur à une minute.

13. Procédé selon la revendication 12, où le temps d'initiation dans un bain de dépôt autocatalytique est inférieur à 30 secondes.

14. Procédé selon la revendication 2 ou la revendication 3, où aucun dépôt étranger ni pontage n'est présent sur l'article.

15. Procédé selon la revendication 2 ou la revendication 3, où la solution de prétraitement comprend en outre un ajusteur du pH.

16. Procédé selon la revendication 2 ou la revendication 3, où la solution de prétraitement comprend en outre un surfactant.

17. Procédé selon la revendication 2 ou la revendication 3, où la solution de prétraitement comprend en outre un agent complexant.
